# FASCICULE DE BREVET EUROPEEN

(11) **EP 2 472 340 B1**
(45) Date de publication et mention de la délivrance du brevet: **03.03.2021**
(21) Numéro de dépôt: 11000012.2
(22) Date de dépôt: 03.01.2011
(51) Int. Cl.: B81B 3/00, G04D 3/00, G04B 1/14, G04B 11/00, G04B 13/02, G04B 15/14, G04B 17/06, G04B 17/32

(54) **Composant horloger et son procédé de fabrication**
Bestandteil einer Uhr und sein Herstellungsverfahren
Timepiece component and method for manufacturing same

(43) Date de publication de la demande: 04.07.2012
(73) Titulaire: Patek Philippe SA Genève, 1204 Genève (CH)
(72) Inventeur: Maier, Frédéric, 2000 Neuchâtel (CH); Musy, Jean-Pierre, 1268 Begnins (CH)
(74) Mandataire: Micheli & Cie SA

(56) Documents cités:
- EP-A1- 0 126 855
- EP-A1- 0 732 635
- EP-A1- 2 263 824
- EP-A1- 2 284 629
- EP-A2- 2 251 746
- DE-B- 1 123 175
- FR-A- 1 136 615

## Description

La présente invention concerne une pièce destinée à être utilisée dans un mécanisme horloger, et son procédé de fabrication. Plus particulièrement, la présente invention concerne une telle pièce obtenue par un procédé de microfabrication, c'est-à-dire un procédé dont la précision d'usinage est de l'ordre du micron ou inférieure au micron.

Dans le domaine horloger, des composants tels que des roues dentées, des échappements, des balanciers et des spiraux sont maintenant faits en silicium. Le silicium présente plusieurs avantages, notamment sa faible densité, son élasticité, son amagnétisme et son aptitude à être usiné par des techniques de gravure.

La demande de brevet EP 0 732 635 A1 décrit un procédé de fabrication d'une pièce de micromécanique horlogère consistant à former un support ayant la forme souhaitée de la pièce par gravure d'un premier matériau, tel que le silicium, l'oxyde de silicium, le nitrure de silicium, le molybdène, le germanium ou l'alumine cristallisée, puis à former sur le support un revêtement d'un deuxième matériau ayant une plus grande dureté et de meilleures propriétés tribologiques que le premier matériau. Le deuxième matériau est par exemple du diamant, du carbone amorphe (DLC), du carbure ou nitrure de titane, du carbure ou nitrure de silicium, du nitrure de bore ou du diborure de titane. Le revêtement est formé sur tout le support ou au moins sur les parties actives, destinées à entrer en contact avec une autre pièce, telles que les dents d'un pignon ou d'une ancre ou la fourchette d'une ancre. La dureté du second matériau vise à éviter une érosion prématurée de la pièce. Quant aux propriétés tribologiques, elles sont considérées comme améliorées dans le cas d'un revêtement de diamant, le diamant présentant un bon coefficient de frottement contre lui-même et contre le carbone amorphe. D'autres couples de matériaux cités comme ayant un bon coefficient de frottement l'un contre l'autre sont le nitrure de titane contre le carbure de titane ou le carbure de silicium.

Dans ce document EP 0 732 635 A1, le silicium est présenté comme ayant un mauvais coefficient de frottement, rendant nécessaire le dépôt d'un revêtement. L'expérience a au contraire montré que, dans les applications horlogères, le coefficient de frottement du silicium sur lui-même et sur l'acier est généralement très bon, et que l'utilisation de surfaces de glissement en silicium permet d'éviter le recours à la lubrification. Des échappements en silicium fonctionnant sans lubrification ont notamment été réalisés. Le diamant n'a, lui, pour le moment pas répondu aux attentes en termes de propriétés tribologiques, probablement du fait de la difficulté à obtenir de bons états de surface.

Par contre, il est bien connu, et cela a été vérifié, que la résistance mécanique du silicium, en particulier sa résistance aux chocs, est faible. Pour cette raison, il a été proposé dans la demande de brevet WO 2007/000271 de renforcer des pièces en silicium par un revêtement d'un matériau amorphe épais, tel que l'oxyde, le nitrure ou le carbure de silicium, le nitrure ou le carbure de titane, l'oxyde de silicium étant le matériau préféré et son épaisseur étant, dans ce cas, au moins cinq fois supérieure à l'épaisseur de l'oxyde de silicium formé naturellement à la surface du silicium au contact de l'air ambiant. Pour améliorer les propriétés tribologiques de la pièce, un revêtement supplémentaire anti-friction tel que du carbone sous forme de diamant (DLC) ou des nanotubes de carbone peut être déposé sur le revêtement de matériau amorphe. Deux revêtements sont donc nécessaires pour garantir une bonne résistance mécanique de la pièce et un bon coefficient de frottement.

La présente invention vise à proposer une autre approche pour réaliser des composants horlogers combinant les propriétés mécaniques de matériaux différents, sans qu'il soit nécessaire, pour cela, de multiplier les revêtements.

A cette fin, il est prévu un mécanisme horloger selon la revendication 1 et un procédé de réalisation d'un mécanisme horloger selon la revendication 10 ou la revendication 13.

Dans la présente invention, une pièce destinée à être utilisée dans un mécanisme horloger comprend un support fait en un premier matériau et un revêtement formé sur le support et fait en un deuxième matériau, différent du premier matériau. Le support comprend au moins une surface non recouverte par le revêtement et destinée à être en contact avec une autre pièce pendant le fonctionnement du mécanisme.

Ainsi, la présente invention utilise les propriétés mécaniques du matériau de support, plutôt que celles du revêtement, pour assurer la coopération entre la pièce selon l'invention et une autre pièce. Le revêtement peut donc avoir des propriétés mécaniques très différentes de celles du matériau de support, pour compenser précisément les faiblesses ou inconvénients du matériau de support, sans devoir lui-même posséder des qualités nécessaires à assurer un bon contact, notamment des qualités tribologiques.

Le matériau de support pourra être choisi pour ses propriétés tribologiques. Le matériau du revêtement pourra, lui, être choisi pour augmenter la résistance mécanique de la pièce, sa raideur ou sa conductibilité électrique en surface (afin notamment de diminuer le caractère électrostatique de la pièce), pour modifier sa mouillabilité (afin que les lubrifiants restent sur les surfaces fonctionnelles, non revêtues) ou pour d'autres effets encore.

Typiquement, ladite surface du support non recouverte par le revêtement est ou fait partie d'un flanc de la pièce selon l'invention.

Le revêtement est de préférence formé au moins sur une surface supérieure et sur une surface inférieure du support.

Ladite surface du support non recouverte par le revêtement peut affleurer sensiblement au moins une surface extérieure adjacente du revêtement.

Le revêtement peut comprendre au moins une surface extérieure qui soit adjacente et située en retrait par rapport à ladite surface du support non recouverte par le revêtement.

Le support est par exemple en silicium, en carbure de silicium, en alumine, en céramique ou en verre.

Le revêtement est par exemple en diamant, en carbure de silicium, en oxyde de silicium, en nitrure, en nitrure de bore, en alumine, en métal ou en polymère.

Dans un mode de réalisation particulier, le support est en silicium et ladite surface du support non recouverte par le revêtement est oxydée.

La pièce selon l'invention est par exemple l'un des composants suivants : roue dentée, pignon denté, ancre d'échappement, organe d'entraînement entre une ancre et un balancier (cheville de plateau), ressort, sautoir.

D'autres caractéristiques et avantages de la présente invention apparaîtront à la lecture de la description détaillée suivante faite en référence aux dessins annexés dans lesquels :
- la figure 1 est une vue en perspective partielle d'une roue d'échappement selon l'invention ;
- la figure 2 est une vue en perspective partielle d'une ancre d'échappement selon l'invention ;
- la figure 3 est un schéma montrant, en coupe, différentes étapes d'un procédé de microfabrication de composants horlogers selon l'invention.

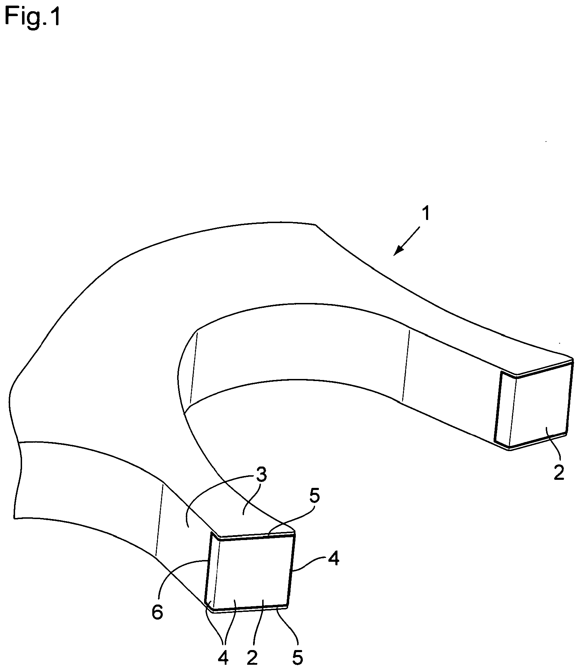

Un mécanisme horloger selon l'invention comprend une pièce 1 et une autre pièce. La pièce 1 est par exemple sous la forme d'une roue d'échappement, dont deux dents sont montrées à la figure 1. La pièce 1 comprend un support ou âme 2 fait en un premier matériau et un revêtement 3 fait en un deuxième matériau, différent du premier. Le support 2 définit la forme de la pièce 1 et le revêtement 3 recouvre tout le support 2 à l'exception des surfaces 4 correspondant aux surfaces de flanc fonctionnelles des dents, c'est-à-dire aux surfaces (plan de repos, bec de repos, plan d'impulsion et bec d'impulsion) destinées à coopérer avec les palettes d'une ancre. Ainsi, ce sont ces surfaces non recouvertes 4 du support 2 qui, éventuellement avec les tranches 5 du revêtement 3, serviront de surfaces de contact et de glissement lorsque la pièce 1 sera utilisée dans un mouvement horloger. Comme cela est visible sur le dessin, les surfaces 4 affleurent les surfaces extérieures du revêtement 3 qui leur sont adjacentes. Le support 2 présente à cet effet, dans des zones 6, des décrochements dont la taille correspond à l'épaisseur du revêtement 3. En variante, toutefois, au moins les tranches 5 du revêtement 3 peuvent être en retrait par rapport aux surfaces 4 pour que seulement ces dernières assurent la fonction de contact avec l'autre pièce.

Le support 2 est par exemple en un matériau cristallin tel que le silicium, le carbure de silicium, l'alumine ou une céramique, ou en un matériau amorphe gravable tel qu'un verre. Le revêtement 3 est par exemple en diamant, en carbure de silicium, en oxyde de silicium, en nitrure, en nitrure de bore, en alumine, en métal ou en polymère. Des couples de matériaux préférés sont le silicium pour le support 2 et le diamant ou le carbure de silicium pour le revêtement 3. Le silicium conférera un bon coefficient de frottement entre la pièce 1 et l'autre pièce avec laquelle elle coopérera, en particulier si les surfaces de contact de l'autre pièce sont elles aussi en silicium. Le diamant ou le carbure de silicium augmentera la résistance mécanique de la pièce 1, lui permettant ainsi d'être moins sensible aux chocs et aux manipulations. Une couche intermédiaire, par exemple de l'oxyde de silicium, peut être formée entre le support 2 et le revêtement 3. Un traitement particulier peut aussi être appliqué aux surfaces non recouvertes 4. Par exemple, dans le cas d'un support 2 réalisé en silicium, la pièce 1 pourra être traitée thermiquement pour qu'une couche d'oxyde de silicium se forme sur les surfaces 4.

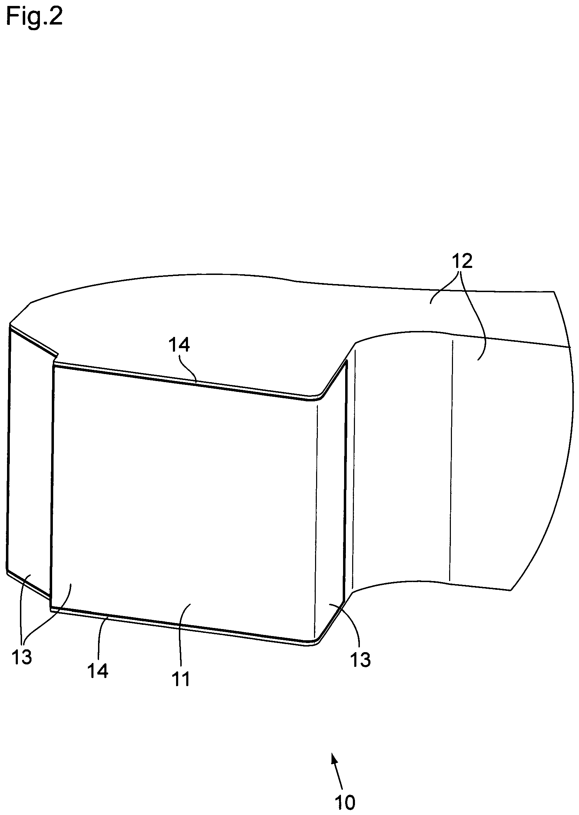

La pièce selon l'invention peut, selon un autre mode de réalisation, être sous la forme d'une ancre d'échappement 10 dont une palette est montrée à la figure 2. Comme la roue d'échappement 1, l'ancre 10 comprend un support ou âme 11 fait en un premier matériau et un revêtement 12 fait en un deuxième matériau, différent du premier. Le support 11 définit la forme de la pièce 10 et le revêtement 12 recouvre tout le support 11 à l'exception des surfaces 13 correspondant aux surfaces de flanc fonctionnelles des palettes, c'est-à-dire des surfaces (plan de repos, bec de repos, plan d'impulsion, bec d'impulsion et revers) destinées à coopérer avec les dents d'une roue d'échappement. Ainsi, ce sont ces surfaces non recouvertes 13 du support 11 qui, éventuellement avec les tranches 14 du revêtement 12, serviront de surfaces de contact et de glissement lorsque la pièce 10 sera utilisée dans un mouvement horloger. Comme cela est visible sur le dessin, les surfaces 13 affleurent les surfaces extérieures du revêtement 12 qui leur sont adjacentes. En variante, toutefois, au moins les tranches 14 du revêtement 12 peuvent être en retrait par rapport aux surfaces 13 pour que seulement ces dernières assurent la fonction de contact avec une autre pièce. Les mêmes matériaux que ceux utilisés pour la roue d'échappement 1 peuvent être utilisés pour l'ancre 10. L'ancre 10 coopérera avantageusement avec la roue d'échappement 1.

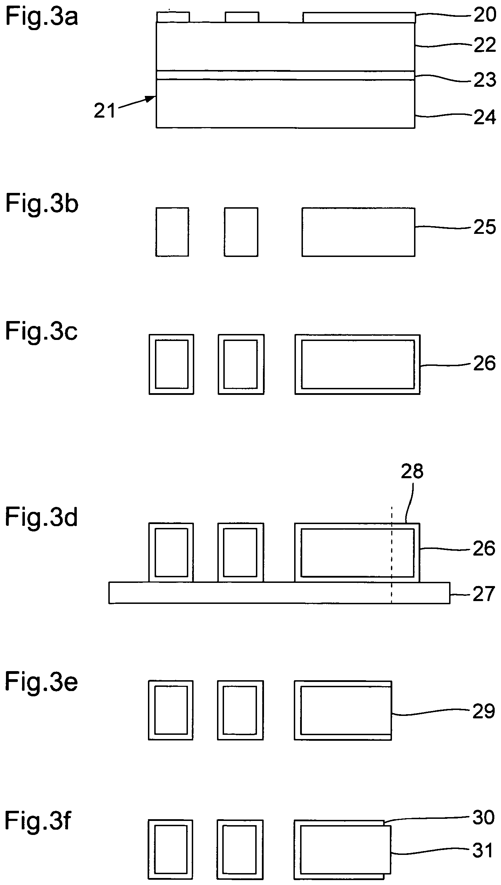

La figure 3 montre un procédé de fabrication permettant la réalisation d'un lot de pièces selon l'invention. Ce procédé est décrit ci-dessous dans le cas du couple de matériaux silicium-diamant.

A une première étape (figure 3a), une couche de résine photosensible 20 est déposée sur un substrat silicium sur isolant SOI (Silicon-On-Insulator) 21 puis structurée par photolithographie en fonction de la forme que l'on souhaite donner à chaque pièce. Le substrat 21 comprend une couche supérieure de silicium 22 sur laquelle est déposée la résine photosensible, une couche intermédiaire d'oxyde de silicium 23 et une couche inférieure de silicium 24.

A une deuxième étape (figure 3b), la couche supérieure de silicium 22 est gravée en utilisant la couche de résine photosensible 20 comme masque, par exemple selon la technique de gravure ionique réactive profonde (DRIE), puis la couche intermédiaire d'oxyde de silicium 23, la couche inférieure de silicium 24 et la résine photosensible 20 sont enlevées, les couches 23 et 24 pouvant éventuellement subsister sur le pourtour et/ou d'autres parties du substrat. On obtient ainsi une dentelle de silicium 25, comprenant un squelette et des pièces en silicium rattachées au squelette. Ces pièces en silicium correspondent au support ou âme des pièces finales. La structuration de la couche de résine photosensible 20 à la première étape est telle que chacune de ces pièces en silicium ait la forme souhaitée mais avec des parties fonctionnelles, destinées, en utilisation, à être en contact avec une ou plusieurs autres pièces, de plus grandes dimensions que celles souhaitées pour la pièce finale. En variante, on peut aussi structurer la couche de résine photosensible 20 de telle sorte qu'à cette deuxième étape, les zones du substrat où les parties fonctionnelles des pièces doivent être formées ne subissent pas la gravure.

A une troisième étape (figure 3c), la dentelle 25 obtenue à la deuxième étape, et donc chacune des pièces en silicium, sont revêtues sur toutes leurs surfaces d'un dépôt de diamant réalisé par exemple par un procédé de dépôt chimique en phase vapeur (CVD), de dépôt physique en phase vapeur (PVD), de pulvérisation, d'évaporation ou de trempage.

A une quatrième étape (figure 3d), la dentelle revêtue 26 est fixée sur une plaque 27, telle qu'une plaque de silicium, par exemple au moyen d'une colle de type SU-8. Une couche de résine photosensible (non représentée) est ensuite déposée sur la dentelle 26 et gravée afin de découvrir les parties d'extrémités 28 des pièces à éliminer pour que les parties fonctionnelles desdites pièces aient les dimensions souhaitées. Ces parties d'extrémités 28 sont alors éliminées par gravure successive de la partie du revêtement se trouvant sur la surface supérieure du support, du support lui-même et de la partie du revêtement se trouvant sur la surface inférieure du support, de manière à former des surfaces de flanc fonctionnelles 29 des pièces (figure 3e), destinées chacune à glisser ou au moins à être contact avec une autre pièce et dont la plus grande partie est en silicium. Dans la variante où, à la deuxième étape, les parties fonctionnelles de la pièce n'ont pas été formées, cette quatrième étape consiste à graver les surfaces de flanc fonctionnelles dans la dentelle revêtue 26.

Le procédé se termine par l'enlèvement de la plaque 27 et la rupture des attaches reliant les pièces au squelette.

A la figure 3f est montrée une variante où la gravure utilise des masques de dimensions différentes pour le revêtement et le support, de sorte que les tranches 30 du revêtement soient en retrait par rapport aux surfaces gravées 31 du support, constituant les surfaces fonctionnelles des pièces.

Un procédé similaire à celui décrit ci-dessus pourra être appliqué à d'autres matériaux.

Dans le cas de pièces dont le support est en silicium, on pourra en outre, comme déjà indiqué, traiter thermiquement lesdites pièces pour qu'une couche d'oxyde de silicium se forme sur les surfaces fonctionnelles.

Selon un autre mode de réalisation du procédé selon l'invention (non représenté sur les dessins), les première à quatrième étapes sont remplacées par des étapes consistant à recouvrir un substrat d'un revêtement sur toutes ses surfaces, ou seulement une partie d'entre elles, et graver le substrat revêtu de sorte à former les surfaces de flanc des pièces et donner ainsi leur forme à chacune des pièces, ces surfaces de flanc, incluant les surfaces fonctionnelles et des surfaces non fonctionnelles, étant ainsi au moins dans leur plus grande partie faites dans le matériau du substrat.

Outre les roues et ancres d'échappement telles que celles illustrées aux figures 1 et 2, le procédé selon l'invention peut être utilisé pour fabriquer toutes sortes de roues et pignons dentés, des organes d'entraînement entre des ancres et des balanciers (chevilles de plateau), des ressorts tels que des sautoirs et de manière générale toute pièce devant, en utilisation, glisser sur une autre pièce.

## Revendications

1. Mécanisme horloger comprenant une première pièce et une deuxième pièce, la première pièce comprenant un support (2) fait en un premier matériau et un revêtement (3) formé sur le support (2) et fait en un deuxième matériau, différent du premier matériau, le support (2) étant en silicium, carbure de silicium, alumine, céramique ou verre, **caractérisé en ce que** le support (2) comprend au moins une surface (4) non recouverte par le revêtement (3) et agencée pour être en contact avec la deuxième pièce pendant le fonctionnement du mécanisme.

2. Mécanisme horloger selon la revendication 1, **caractérisé en ce que** ladite surface (4) du support (2) non recouverte par le revêtement (3) est ou fait partie d'un flanc de la première pièce.

3. Mécanisme horloger selon la revendication 1 ou 2, **caractérisé en ce que** le revêtement (3) est formé au moins sur une surface supérieure et sur une surface inférieure du support (2).

4. Mécanisme horloger selon l'une quelconque des revendications 1 à 3, **caractérisé en ce que** ladite surface (4) du support (2) non recouverte par le revêtement (3) affleure sensiblement au moins une surface extérieure adjacente du revêtement (3).

5. Mécanisme horloger selon l'une quelconque des revendications 1 à 4, **caractérisé en ce que** le revêtement (3) comprend au moins une surface extérieure (5, 30) qui est adjacente et située en retrait par rapport à ladite surface (4) du support (2) non recouverte par le revêtement (3).

6. Mécanisme horloger selon l'une quelconque des revendications 1 à 5, **caractérisé en ce que** le revêtement (3) est en diamant, carbure de silicium, oxyde de silicium, nitrure, nitrure de bore, alumine, métal ou polymère.

7. Mécanisme horloger selon l'une quelconque des revendications 1 à 6, **caractérisé en ce que** le support (2) est en silicium et le revêtement (3) est en diamant ou carbure de silicium.

8. Mécanisme horloger selon l'une quelconque des revendications 1 à 7, **caractérisé en ce que** le support (2) est en silicium et ladite surface (4) du support (2) non recouverte par le revêtement (3) est oxydée.

9. Mécanisme horloger selon l'une quelconque des revendications 1 à 8, **caractérisé en ce que** la première pièce consiste en l'un des composants suivants: roue dentée (1), pignon denté, ancre d'échappement (10), organe d'entraînement entre une ancre et un balancier, ressort, sautoir.

10. Procédé de réalisation d'un mécanisme horloger, comprenant les étapes suivantes :
a) former au moins un support (25) par gravure d'un premier matériau,
b) former sur le support un revêtement d'un deuxième matériau, différent du premier matériau,
**caractérisé en ce qu'**il comprend les étapes supplémentaires suivantes :
c) graver le support revêtu (26) de sorte à former au moins une surface (29) du support non recouverte par le revêtement, et
d) agencer la pièce ainsi obtenue dans ledit mécanisme horloger de telle sorte que la surface (29) du support non recouverte par le revêtement soit en contact avec une autre pièce dudit mécanisme horloger pendant le fonctionnement du mécanisme.

11. Procédé selon la revendication 10, **caractérisé en ce que** l'étape c) comprend la gravure successive d'une première couche du revêtement, du support et d'une deuxième couche du revêtement.

12. Procédé selon la revendication 10 ou 11, **caractérisé en ce qu'**à l'étape b) le revêtement est formé sur toutes les surfaces du support.

13. Procédé de réalisation d'un mécanisme horloger, comprenant l'étape suivante :
a) se munir d'un substrat fait en un premier matériau,
**caractérisé en ce qu'**il comprend les étapes supplémentaires suivantes :
b) former sur le substrat un revêtement d'un deuxième matériau, différent du premier matériau,
c) graver le substrat revêtu pour former au moins une pièce, ladite au moins une pièce comprenant un support (2) recouvert par le revêtement (3), le support (2) comprenant au moins une surface (4) non recouverte par le revêtement (3), et
d) agencer la pièce ainsi obtenue dans ledit mécanisme horloger de telle sorte que la surface (4) du support non recouverte par le revêtement soit en contact avec une autre pièce dudit mécanisme horloger pendant le fonctionnement du mécanisme.

14. Procédé selon la revendication 13, **caractérisé en ce que** l'étape c) comprend la gravure successive d'une première couche du revêtement, du substrat et d'une deuxième couche du revêtement.

15. Procédé selon la revendication 13 ou 14, **caractérisé en ce qu'**à l'étape b) le revêtement est formé sur toutes les surfaces du substrat.

16. Procédé selon l'une quelconque des revendications 10 à 15, **caractérisé en ce que** l'étape c) est réalisée de telle sorte que ladite surface (4, 29) du support non recouverte par le revêtement constitue ou fasse partie d'un flanc de ladite pièce.

17. Procédé selon l'une quelconque des revendications 10 à 16, **caractérisé en ce que** le premier matériau est le silicium, le carbure de silicium, l'alumine, une céramique ou un verre.

18. Procédé selon l'une quelconque des revendications 10 à 17, **caractérisé en ce que** le deuxième matériau est le diamant, le carbure de silicium, l'oxyde de silicium, un nitrure, le nitrure de bore, l'alumine, un métal ou un polymère.

19. Procédé selon l'une quelconque des revendications 10 à 18, **caractérisé en ce que** le premier matériau est le silicium et **en ce qu'**une étape supplémentaire de traitement thermique est mise en œuvre pour oxyder ladite surface (4, 29) du support non recouverte par le revêtement.

20. Procédé selon l'une quelconque des revendications 10 à 19, **caractérisé en ce que** ladite pièce est l'une des pièces suivantes : roue dentée (1), pignon denté, ancre d'échappement (10), organe d'entraînement entre une ancre et un balancier, ressort, sautoir.

## Patentansprüche

1. Uhrmechanismus, der ein erstes Teil und ein zweites Teil umfasst, wobei das erste Teil eine Stütze (2), die aus einem ersten Material hergestellt ist, und einen Überzug (3) umfasst, der auf der Stütze (2) gebildet ist und aus einem zweiten Material hergestellt ist, das sich von dem ersten Material unterscheidet, wobei die Stütze (2) aus Silizium, Siliziumcarbid, Aluminiumoxid, Keramik oder Glas ist, **dadurch gekennzeichnet, dass** die Stütze (2) mindestens eine Fläche (4) umfasst, die nicht von dem Überzug (3) bedeckt ist und angeordnet ist, um während des Betriebs des Mechanismus mit dem zweiten Teil in Kontakt zu sein.

2. Uhrmechanismus nach Anspruch 1, **dadurch gekennzeichnet, dass** die nicht von dem Überzug (3) bedeckte Fläche (4) der Stütze (2) eine Flanke des ersten Teils oder ein Bestandteil davon ist.

3. Uhrmechanismus nach Anspruch 1 oder 2, **dadurch gekennzeichnet, dass** der Überzug (3) mindestens auf einer oberen Fläche und auf einer unteren Fläche der Stütze (2) gebildet ist.

4. Uhrmechanismus nach einem der Ansprüche 1 bis 3, **dadurch gekennzeichnet, dass** die nicht von dem Überzug (3) bedeckte Fläche (4) der Stütze (2) im Wesentlichen mit mindestens einer benachbarten äußeren Fläche des Überzugs (3) bündig ist.

5. Uhrmechanismus nach einem der Ansprüche 1 bis 4, **dadurch gekennzeichnet, dass** der Überzug (3) mindestens eine äußere Fläche (5, 30) umfasst, die benachbart ist und sich in Bezug auf die nicht von dem Überzug (3) bedecke Fläche (4) der Stütze (2) eingerückt befindet.

6. Uhrmechanismus nach einem der Ansprüche 1 bis 5, **dadurch gekennzeichnet, dass** der Überzug (3) aus Diamant, Siliziumcarbid, Siliziumoxid, Nitrid, Bornitrid, Aluminiumoxid, Metall oder Polymer ist.

7. Uhrmechanismus nach einem der Ansprüche 1 bis 6, **dadurch gekennzeichnet, dass** die Stütze (2) aus Silizium ist und der Überzug (3) aus Diamant oder Siliziumcarbid ist.

8. Uhrmechanismus nach einem der Ansprüche 1 bis 7, **dadurch gekennzeichnet, dass** die Stütze (2) aus Silizium ist und die nicht von dem Überzug (3) bedecke Fläche (4) der Stütze (2) oxidiert ist.

9. Uhrmechanismus nach einem der Ansprüche 1 bis 8, **dadurch gekennzeichnet, dass** das erste Teil aus einem der folgenden Bauteile besteht: Zahnrad (1), Zahntrieb, Hemmungsanker (10), Antriebsorgan zwischen einem Anker und einer Unruh, Feder, Hebelfeder.

10. Verfahren zur Herstellung eines Uhrmechanismus, das die folgenden Schritte umfasst:
a) Bilden von mindestens einer Stütze (25) durch Gravur eines ersten Materials,
b) Bilden eines Überzugs aus einem zweiten Material, das sich von dem ersten Material unterscheidet, auf der Stütze,
**dadurch gekennzeichnet, dass** es die folgenden zusätzlichen Schritte umfasst:
c) Gravieren der überzogenen Stütze (26), derart dass mindestens eine Fläche (29) der Stütze gebildet wird, die nicht von dem Überzug bedeckt ist, und
d) Anordnen des so erhaltenen Teils in dem Uhrmechanismus, derart dass die nicht von dem Überzug bedeckte Fläche (29) der Stütze während des Betriebs des Mechanismus mit einem anderen Teil des Uhrmechanismus in Kontakt ist.

11. Verfahren nach Anspruch 10, **dadurch gekennzeichnet, dass** der Schritt c) die aufeinanderfolgende Gravur einer ersten Schicht des Überzugs, der Stütze und einer zweiten Schicht des Überzugs umfasst.

12. Verfahren nach Anspruch 10 oder 11, **dadurch gekennzeichnet, dass** im Schritt b) der Überzug auf sämtlichen Flächen der Stütze gebildet wird.

13. Verfahren zur Herstellung eines Uhrmechanismus, das den folgenden Schritt umfasst:
a) Bereitstellen eines Substrats, das aus einem ersten Material besteht,
**dadurch gekennzeichnet, dass** es die folgenden zusätzlichen Schritte umfasst:
b) Bilden eines Überzugs aus einem zweiten Material, das sich von dem ersten Material unterscheidet, auf dem Substrat,
c) Gravur des überzogenen Substrats zum Bilden von mindestens einem Teil, wobei das mindestens eine Teil eine von dem Überzug (3) bedeckte Stütze (2) umfasst, wobei die Stütze (2) mindestens eine nicht von dem Überzug (3) bedeckte Fläche (4) umfasst, und
d) Anordnen des so erhaltenen Teils in dem Uhrmechanismus, derart dass die nicht von dem Überzug bedeckte Fläche (4) der Stütze während des Betriebs des Mechanismus mit einem anderen Teil des Uhrmechanismus in Kontakt ist.

14. Verfahren nach Anspruch 13, **dadurch gekennzeichnet, dass** der Schritt c) die aufeinanderfolgende Gravur einer ersten Schicht des Überzugs, des Substrats und einer zweiten Schicht des Überzugs umfasst.

15. Verfahren nach Anspruch 13 oder 14, **dadurch gekennzeichnet, dass** im Schritt b) der Überzug auf sämtlichen Flächen des Substrats gebildet wird.

16. Verfahren nach einem der Ansprüche 10 bis 15, **dadurch gekennzeichnet, dass** der Schritt c) derart ausgeführt wird, dass die Fläche (4, 29) der Stütze, die nicht von dem Überzug bedeckt ist, eine Flanke des Teils bildet oder ein Bestandteil davon ist.

17. Verfahren nach einem der Ansprüche 10 bis 16, **dadurch gekennzeichnet, dass** das erste Material Silizium, Siliziumcarbid, Aluminiumoxid, eine Keramik oder ein Glas ist.

18. Verfahren nach einem der Ansprüche 10 bis 17, **dadurch gekennzeichnet, dass** das zweite Material Diamant, Siliziumcarbid, Siliziumoxid, ein Nitrid, Bornitrid, Aluminiumoxid, ein Metall oder ein Polymer ist.

19. Verfahren nach einem der Ansprüche 10 bis 18, **dadurch gekennzeichnet, dass** das erste Material Silizium ist, und dadurch, dass ein zusätzlicher Schritt zur Wärmebehandlung durchgeführt wird, um die nicht von dem Überzug bedecke Fläche (4, 29) der Stütze zu oxidieren.

20. Verfahren nach einem der Ansprüche 10 bis 19, **dadurch gekennzeichnet, dass** das Teil eines von den folgenden Teilen ist: Zahnrad (1), Zahntrieb, Hemmungsanker (10), Antriebsorgan zwischen einem Anker und einer Unruh, Feder und Hebelfeder.

## Claims

1. Timepiece mechanism comprising a first part and a second part, the first part comprising a support (2) made from a first material and a coating (3) formed on the support (2) and made from a second material, different from the first material, the support (2) being made from silicon, silicon carbide, alumina, ceramic or glass, **characterised in that** the support (2) comprises at least one surface (4) not covered by the coating (3) and arranged to be in contact with the second part during operation of the mechanism.

2. Timepiece mechanism as claimed in claim 1, **characterised in that** said surface (4) of the support (2) not covered by the coating (3) is, or forms part of, a flank of the first part.

3. Timepiece mechanism as claimed in claim 1 or 2, **characterised in that** the coating (3) is formed at least on an upper surface and on a lower surface of the support (2).

4. Timepiece mechanism as claimed in any one of claims 1 to 3, **characterised in that** said surface (4) of the support (2) not covered by the coating (3) is substantially flush with at least one adjacent outer surface of the coating (3).

5. Timepiece mechanism as claimed in any one of claims 1 to 4, **characterised in that** the coating (3) comprises at least one outer surface (5, 30) which is adjacent to, and set back with respect to, said surface (4) of the support (2) not covered by the coating (3).

6. Timepiece mechanism as claimed in any one of claims 1 to 5, **characterised in that** the coating (3) is made from diamond, silicon carbide, silicon oxide, nitride, boron nitride, alumina, metal or polymer.

7. Timepiece mechanism as claimed in any one of claims 1 to 6, **characterised in that** the support (2) is made from silicon and the coating (3) is made from diamond or silicon carbide.

8. Timepiece mechanism as claimed in any one of claims 1 to 7, **characterised in that** the support (2) is made from silicon and said surface (4) of the support (2) not covered by the coating (3) is oxidised.

9. Timepiece mechanism as claimed in any one of claims 1 to 8, **characterised in that** the first part consists of one of the following components: toothed wheel (1), toothed pinion, escapement anchor (10), drive member between an anchor and a balance, spring, jumper.

10. Method of producing a timepiece mechanism, comprising the following steps:
a) forming at least one support (25) by etching a first material,
b) forming on the support a coating of a second material, different from the first material, **characterised in that** it comprises the following additional steps:
c) etching the coated support (26) so as to form at least one surface (29) of the support not covered by the coating, and
d) arranging the part thus obtained in said timepiece mechanism so that the surface (29) of the support not covered by the coating is in contact with another part of said timepiece mechanism during operation of the mechanism.

11. Method as claimed in claim 10, **characterised in that** step c) comprises the successive etching of a first layer of the coating, of the support and of a second layer of the coating.

12. Method as claimed in claim 10 or 11, **characterised in that** in step b) the coating is formed on all the surfaces of the support.

13. Method of producing a timepiece mechanism, comprising the following step:
a) obtaining a substrate made from a first material,
**characterised in that** it comprises the following additional steps:
b) forming on the substrate a coating of a second material, different from the first material,
c) etching the coated substrate to form at least one part, said at least one part comprising a support (2) covered by the coating (3), the support (2) comprising at least one surface (4) not covered by the coating (3), and
d) arranging the part thus obtained in said timepiece mechanism so that the surface (4) of the support not covered by the coating is in contact with another part of said timepiece mechanism during operation of the mechanism.

14. Method as claimed in claim 13, **characterised in that** step c) comprises the successive etching of a first layer of the coating, of the substrate and of a second layer of the coating.

15. Method as claimed in claim 13 or 14, **characterised in that** in step b) the coating is formed on all the surfaces of the substrate.

16. Method as claimed in any one of claims 10 to 15, **characterised in that** step c) is carried out so that said surface (4, 29) of the support not covered by the coating constitutes, or forms part of, a flank of said part.

17. Method as claimed in any one of claims 10 to 16, **characterised in that** the first material is silicon, silicon carbide, alumina, a ceramic or a glass.

18. Method as claimed in any one of claims 10 to 17, **characterised in that** the second material is diamond, silicon carbide, silicon oxide, a nitride, boron nitride, alumina, a metal or a polymer.

19. Method as claimed in any one of claims 10 to 18, **characterised in that** the first material is silicon and **in that** an additional step of thermal treatment is carried out in order to oxidise said surface (4, 29) of the support not covered by the coating.

20. Method as claimed in any one of claims 10 to 19, **characterised in that** said part is one of the following parts: toothed wheel (1), toothed pinion, escapement anchor (10), drive member between an anchor and a balance, spring, jumper.
